# FASCICULE DE BREVET EUROPEEN

(11) **EP 2 884 529 B1**
(45) Date de publication et mention de la délivrance du brevet: **05.12.2018**
(21) Numéro de dépôt: 14195160.8
(22) Date de dépôt: 27.11.2014
(51) Int. Cl.: H01L 23/10, H01L 23/26, H01L 23/31, C23F 1/04, H05K 3/46, B81C 1/00

(54) **Procédé de réalisation d'un substrat comportant un matériau getter disposé sur des parois d'un ou plusieurs trous borgnes formés dans le substrat**
Verfahren zur Herstellung eines Substrats, das ein Gettermaterial umfasst, das auf den Wänden eines oder mehrerer Klemmenlöcher im Substrat verteilt ist
Method for producing a substrate comprising a getter material arranged on the walls of one or more blind holes formed in the substrate

(30) Priorité: 29.11.2013 FR 1361828
(43) Date de publication de la demande: 17.06.2015
(73) Titulaire: Commissariat à l'Énergie Atomique et aux Énergies Alternatives, 75015 Paris (FR)
(72) Inventeur: Giroud, Sophie, 38120 SAINT-EGREVE (FR); Ferrandon, Christine, 38360 SASSENAGE (FR)
(74) Mandataire: Brevalex

(56) Documents cités:
- DE-A1-102008 060 796
- FR-A1- 2 967 302
- US-A1- 2001 050 439
- US-A1- 2002 070 421
- US-A1- 2004 077 117

## Description

### DOMAINE TECHNIQUE ET ART ANTÉRIEUR

L'invention concerne un procédé de réalisation d'un substrat, ou wafer, comportant au moins un matériau getter disposé sur des parois d'au moins un trou borgne formé dans le substrat. Un tel substrat est avantageusement utilisé pour réaliser une encapsulation d'un ou plusieurs dispositifs microélectroniques, par exemple de type MEMS (microsystème électromécanique) et/ou NEMS (nanosystème électromécanique) et/ou MOEMS (microsystème opto-électromécanique) et/ou NOEMS (nanosystème opto-électromécanique), dans une cavité dont au moins une paroi est formée par ce substrat telle que le ou les trous borgnes dont les parois sont recouvertes du matériau getter soient exposés dans la cavité.

Certains dispositifs microélectroniques, par exemple de type MEMS et/ou NEMS et/ou MOEMS et/ou NOEMS, doivent être encapsulés dans une cavité sous atmosphère contrôlée (contrôle de la pression et/ou du ou des gaz présents dans l'atmosphère) pour fonctionner correctement. Une telle encapsulation est par exemple réalisée via un report d'un capot, formé par un premier substrat, sur un support, formé par un deuxième substrat, comportant le ou les dispositifs microélectroniques, puis un scellement du capot au support. Un tel scellement peut être réalisé avec différentes méthodes, par exemple via l'utilisation d'un cordon d'alliage eutectique disposé entre le support et le capot. Lors de ce report de capot, les matériaux du dispositif microélectronique peuvent dégazer et dégrader l'atmosphère contrôlée dans laquelle le dispositif est encapsulé.

Pour limiter ce phénomène de dégazage, une cavité supplémentaire est généralement réalisée dans une partie non active du support et/ou du capot. Cette cavité supplémentaire est réalisée telle que son volume corresponde au moins au volume d'expansion des espèces dégazées lors du scellement ou au cours de la vie du ou des dispositifs microélectroniques. Toutefois, pour atteindre dans la cavité une pression inférieure à environ 1 mbar, une telle cavité supplémentaire n'est en général pas suffisante.

Afin d'améliorer et maintenir le vide dans la cavité, un matériau getter est généralement disposé dans la cavité. Un tel matériau getter, souvent métallique, est apte à réaliser une absorption et/ou une adsorption de gaz après avoir été activé thermiquement. Un tel matériau getter est déposé sur la surface de l'un des substrats formant la cavité d'encapsulation, et le plus souvent au niveau du capot. Ce matériau getter est généralement déposé à travers un pochoir afin de réaliser un dépôt localisé d'une ou plusieurs portions de matériau getter. Cette méthode de formation et structuration du matériau getter par pochoir est préférée à une méthode standard de la microélectronique mettant en oeuvre un dépôt, une lithographie et une gravure d'une couche de matériau getter car elle ne nécessite pas la mise en oeuvre d'étape de lithographie qui peut être problématique en présence de cavités profondes (profondeur supérieure à 10 µm) et pouvant potentiellement contaminer le matériau getter.

Toutefois, un dépôt de matériau getter à travers un pochoir présente plusieurs inconvénients :
- un coût de réalisation important,
- les montages des pochoirs sont délicats à mettre en oeuvre et doivent être réalisés substrat par substrat, et sont donc industriellement cher à réaliser,
- le positionnement du pochoir par rapport aux zones à recouvrir par le matériau getter est délicat ce qui impose de prendre une marge importante sur le dessin, ou design, du composant pour cet alignement et consomme de la place inutilement sur le substrat destiné à recevoir le matériau getter, et augmente donc le coût du composant,
- il est nécessaire de réserver, sur la surface du substrat destiné à recevoir le matériau getter, des zones pour poser le matériau getter, de préférence loin des structures existantes pour ne pas générer de perturbations électriques, d'où une consommation de surface du substrat et un coût importants.

Le document US 2007/0262428 A1 décrit un procédé de réalisation d'un capot dans lequel des zones d'indentation sont réalisées. Un matériau getter est déposé de façon localisé dans chacune de ces zones indentées via l'utilisation d'un pochoir. Avec un tel procédé, les interconnexions électriques doivent donc être reportées en-dehors de ces zones indentées, ce qui réduit la densité d'intégration pouvant être atteinte avec un tel procédé. De plus, ce procédé fait appel à un masque tel qu'un pochoir, ce qui induit un coût supplémentaire pour la mise en oeuvre de ce procédé et limite le facteur de forme possible des indentations.

Les documents DE 10 2008 060796 A1, FR 2 967 302 A1, US 2002/070421 A1, US 2004/077117 A1 et US 2001/050439 A1 font partie de l'art antérieur.

### EXPOSÉ DE L'INVENTION

Un but de la présente invention est de proposer un procédé de réalisation d'un substrat comportant un matériau getter ne présentant pas les inconvénients liés au dépôt d'un matériau getter à travers un masque tel qu'un pochoir, ni ceux liés à la réalisation d'un matériau getter par dépôt, lithographie et gravure.

Pour cela, la présente invention propose un procédé de réalisation d'un substrat comportant au moins un matériau getter disposé sur des parois d'au moins un trou borgne, comportant au moins les étapes de :
- gravure du trou borgne à travers une première face du substrat,
- dépôt d'une couche de matériau getter de manière continue sur l'ensemble de la première face du substrat et au moins sur des parois latérales du trou borgne,
- gravure d'une partie de la couche de matériau getter se trouvant sur la première face du substrat telle que ladite première face du substrat ne soit plus recouverte par le matériau getter.

Le procédé selon l'invention permet de réaliser une portion de matériau getter dans le substrat, ou wafer, sans mettre en oeuvre d'étape de photolithographie ou de dépôt à travers un pochoir, ce qui permet d'éviter les inconvénients précédemment décrits liés à de telles étapes. En outre, le facteur de forme du ou des trous borgnes réalisés n'est pas limité par l'utilisation d'un pochoir.

De plus, le dépôt du matériau getter et la gravure de la partie du matériau getter se trouvant en dehors du ou des trous borgnes permet de réaliser une ou plusieurs portions de matériau getter auto-alignées avec le ou les trous borgnes, ce qui résout les problèmes de tolérance d'alignement à prévoir dans le cas d'un dépôt par pochoir, et permet de ne pas consommer de surface du substrat inutilement pour l'alignement du pochoir.

Le procédé selon l'invention permet également de positionner très précisément le matériau getter sur le substrat, et d'éviter par exemple que ce matériau getter ne se retrouve à proximité d'éventuelles lignes de contact électrique ou électrodes, ou d'autres éléments, présentes sur la première face du substrat, limitant ainsi les bruits électriques liés à la présence du matériau getter.

Le procédé selon l'invention optimise également l'utilisation de la surface du substrat, et plus précisément celle de la première face du substrat, en utilisant les parois latérales du ou des trous borgnes et éventuellement la paroi de fond du ou de chacun des trous borgnes pour disposer le matériau getter. La forme et la surface de matériau getter déposé peuvent être ainsi optimisées.

Le procédé selon l'invention permet en outre d'obtenir des surfaces ou volumes de matériau getter importants sans augmenter la taille du ou des trous borgnes grâce à la surface développée sur les parois du ou des trous borgnes.

Le ou les trous borgnes peuvent être réalisés juste avant le dépôt de la couche de matériau getter, ou antérieurement lors de la réalisation du substrat.

L'étape de gravure d'une partie de la couche de matériau getter comporte la mise en oeuvre d'une gravure par usinage ionique, ou une planarisation ou un polissage mécano-chimique. De telles méthodes de gravure permettent de réaliser une gravure locale du matériau getter sans faire appel à un masque de gravure, et sont compatibles avec tous les matériaux getter.

La couche de matériau getter peut être également déposée sur une paroi de fond du trou borgne. Cette partie de la couche de matériau getter déposée sur la paroi de fond du trou borgne peut être conservée et donc ne pas être gravée lors de l'étape de gravure d'une partie de la couche de matériau getter, ce qui permet d'augmenter la surface de matériau getter formé sur le substrat.

L'étape de gravure d'une partie de la couche de matériau getter peut être mise en oeuvre telle que le matériau getter déposé sur la paroi de fond du trou borgne soit également gravé.

Selon une première variante de réalisation, le procédé peut comporter en outre, entre l'étape de gravure du trou borgne et l'étape de dépôt de la couche de matériau getter, une étape de dépôt d'une couche diélectrique de protection sur la première face du substrat et au moins sur les parois latérales du trou borgne, la couche de matériau getter étant déposée ensuite sur la couche diélectrique de protection. Cette couche diélectrique de protection peut servir de couche d'arrêt de gravure lors de la mise en oeuvre de l'étape de gravure d'une partie de la couche de matériau getter. De plus, cette couche diélectrique de protection permet de protéger les éventuelles structures ou éléments, par exemple des lignes électriques ou des éléments de contact électrique, présents sur la première face du substrat, par exemple vis-à-vis du matériau getter déposé et/ou de la gravure mise en oeuvre pour supprimer la partie de la couche de matériau getter se trouvant sur la première face du substrat. Les portions de la couche diélectrique de protection se trouvant sur les parois latérales du ou des trous borgnes, et éventuellement sur la paroi de fond du ou de chacun des trous borgnes, assurent en outre une isolation électrique des parois sur lesquelles se trouve la couche diélectrique de protection.

L'étape de gravure d'une partie de la couche de matériau getter peut réaliser également la gravure d'une partie de la couche diélectrique de protection se trouvant sur la première face du substrat telle que la première face du substrat ne soit plus recouverte par la couche diélectrique de protection. Dans ce cas, des portions de la couche diélectrique de protection sont conservées sur les parois latérales du ou des trous borgnes, et éventuellement sur la paroi de fond du ou de chacun des trous borgnes, afin d'assurer une isolation électrique de ces parois.

Selon une deuxième variante de réalisation, le procédé peut comporter en outre, avant l'étape de gravure du trou borgne, une étape de dépôt d'une couche diélectrique de protection sur la première face du substrat, le trou borgne étant ensuite gravé également à travers la couche diélectrique de protection. Dans ce cas, la couche diélectrique de protection peut servir de couche d'arrêt de gravure lors de la mise en oeuvre de l'étape de gravure d'une partie de la couche de matériau getter se trouvant sur la première face du substrat et/ou permettre de protéger les éventuelles structures ou éléments, par exemple des lignes électriques ou des éléments de contact électrique, présents sur la première face du substrat.

Le trou borgne peut comporter, dans un plan parallèle à la première face du substrat, une section de forme circulaire et/ou polygonale, ou le trou borgne peut former une tranchée traversant une partie de l'épaisseur du substrat.

L'étape de gravure du trou borgne peut former plusieurs trous borgnes à travers la première face du substrat, et la couche de matériau getter peut être déposée au moins sur les parois latérales des trous borgnes.

Dans ce cas, au moins une partie des trous borgnes peuvent être réalisés sous la forme d'un réseau régulier de trous. Cette configuration permet d'optimiser la surface occupée par les trous borgnes au niveau de la première face du substrat. Les trous borgnes peuvent communiquer ou non entre eux, et peuvent être indépendants ou non les uns des autres.

Le procédé peut comporter en outre, avant l'étape de gravure du trou borgne, une étape de :
- réalisation d'au moins un dispositif microélectronique sur la première face du substrat, le ou les trous borgnes étant gravés à côté du dispositif microélectronique, et/ou
- réalisation d'au moins un élément électriquement conducteur sur la première face du substrat, le ou les trous borgnes étant gravés à côté de l'élément électriquement conducteur.

Le dispositif microélectronique peut être de type MEMS et/ou NEMS et/ou MOEMS et/ou NOEMS.

La couche de matériau getter peut comporter du titane et/ou du zirconium et/ou de l'aluminium et/ou du lanthane et/ou de l'hafnium et/ou du chrome et/ou du cobalt et/ou du fer et/ou du magnésium et/ou du manganèse et/ou du molybdène et/ou du niobium et/ou du tantale et/ou du vanadium.

L'invention concerne également un procédé d'encapsulation d'au moins un dispositif microélectronique, comportant la mise en oeuvre d'un procédé de réalisation d'un substrat tel que décrit précédemment, et comportant en outre une étape d'encapsulation du dispositif microélectronique dans une cavité dont une ou plusieurs parois sont formées par ledit substrat et telle que le ou les trous borgnes sont disposés dans la cavité, le dispositif microélectronique étant réalisé sur ledit substrat ou ledit substrat formant un capot de la cavité dans laquelle le dispositif microélectronique est encapsulé.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1C représentent les étapes d'un procédé de réalisation d'un substrat comportant un matériau getter disposé sur des parois d'au moins un trou borgne, objet de la présente invention, selon un premier mode de réalisation ;
- la figure 2 représente un substrat obtenu par la mise en oeuvre d'un procédé de réalisation, objet de la présente invention, selon une variante du premier mode de réalisation ;
- la figure 3 représente plusieurs configurations de trous borgnes formés lors de la mise en oeuvre d'un procédé de réalisation d'un substrat comportant un matériau getter disposé sur des parois de trous borgnes, objet de la présente invention ;
- les figures 4A à 4C représentent les étapes d'un procédé de réalisation d'un substrat comportant un matériau getter disposé sur des parois d'au moins un trou borgne, objet de la présente invention, selon un deuxième mode de réalisation ;
- les figures 5A à 5C représentent une partie des étapes d'un procédé de réalisation d'un substrat comportant un matériau getter disposé sur des parois d'au moins un trou borgne, objet de la présente invention, selon une variante du deuxième mode de réalisation ;
- la figure 6 représente une structure d'encapsulation obtenue par la mise en oeuvre d'un procédé d'encapsulation d'un dispositif microélectronique, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

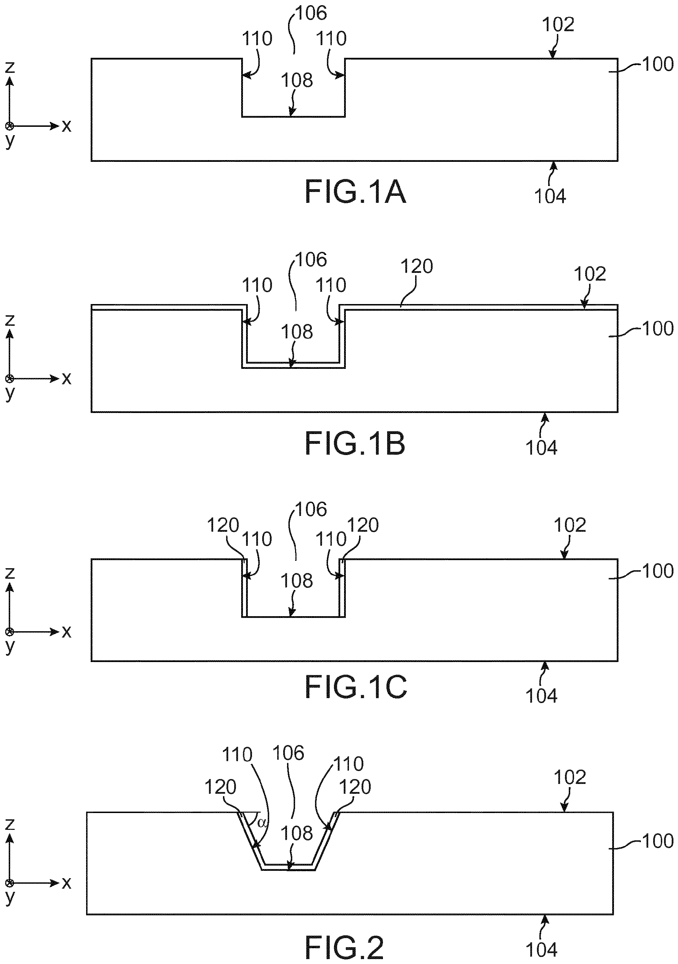

On se réfère tout d'abord aux figures 1A à 1C qui représentent les étapes d'un procédé de réalisation d'un substrat comportant au moins un matériau getter disposé sur des parois d'au moins un trou borgne selon un premier mode de réalisation. Les figures 1A à 1C sont des vues en coupe de profil du substrat réalisé.

Ce procédé est mis en oeuvre à partir d'un substrat 100, correspondant ici à un wafer de silicium. Le substrat 100 peut également être à base d'un matériau autre que du silicium, par exemple un autre semi-conducteur ou du verre, ou encore du SiC, ou être formé par un empilement de plusieurs couches. L'épaisseur du substrat 100 (dimension selon l'axe Z représenté sur les figures 1A à 1C) est par exemple supérieure à environ 250 µm afin d'avoir une bonne tenue mécanique. Ce substrat 100 comporte une première face principale 102 et une deuxième face principale 104 opposée à la première face 102. Un ou plusieurs trous borgnes 106 sont gravés à travers la première face 102 du substrat 100 et dans une partie de l'épaisseur du substrat 100 tels que la ou les parois de fond 108 du ou des trous borgnes 106 soient formées par le substrat 100. Sur les figures 1A à 1C, un seul trou borgne 106 est représenté.

La profondeur du ou des trous borgnes 106 est inférieure à l'épaisseur du substrat 100 et est par exemple comprise entre environ 1 µm et plusieurs centaines de microns, selon l'épaisseur du substrat 100. Les dimensions du ou des trous borgnes 106, dans un plan parallèle à la première face 102 du substrat 100, c'est-à-dire un plan parallèle au plan (X,Y) représenté sur les figures 1A à 1C, sont par exemple comprises entre environ 1 µm et plusieurs centaines de microns. Le nombre de trous borgnes 106 et leurs dimensions sont fonction de la surface de matériau getter destiné à être réalisé sur les parois du ou des trous borgnes 106 ainsi que, lorsque le matériau getter est destiné à être exposé à l'atmosphère d'une cavité dans laquelle un dispositif microélectronique est encapsulé, du volume d'expansion souhaité dans la cavité et donc de la pression désirée dans la cavité.

De plus, le ou les trous borgnes 106 peuvent avoir des formes variées et comporter par exemple chacun, dans le plan parallèle à la première face 102 du substrat 100, une section de forme circulaire ou en forme de disque, ou polygonale telle qu'une section carrée ou rectangulaire. En variante, le ou les trous borgnes 106 peuvent correspondre à des tranchées, c'est-à-dire comporter, dans le plan parallèle à la première face 102 du substrat 100, une forme allongée selon une direction appartenant à ce plan. Le trou borgne 106 représenté sur les figures 1A à 1C comporte, dans le plan parallèle à la première face 102 du substrat 100, une section de forme circulaire.

Le ou les trous borgnes 106 comportent des parois latérales 110. Sur l'exemple des figures 1A à 1C, ces parois latérales 110 forment un angle d'environ 90° avec la première face 102 du substrat 100, c'est-à-dire appartiennent à au moins un plan perpendiculaire à la première face 102 du substrat 100. Selon une variante de réalisation, ces parois latérales peuvent ne pas être perpendiculaires à la première face 102 du substrat 100. Ainsi, comme représenté sur la figure 2, les parois latérales 110 du ou des trous borgnes 106 forment un angle α avec la première face 102 du substrat 100, cet angle α étant inférieur à 90°, par exemple compris entre 80° et 90°. Le ou chacun des trous borgnes 106 a dans ce cas une forme de cône tronqué, les dimensions de la section du ou de chacun des trous borgne 106 au niveau de la paroi de fond 108 étant inférieures à celles au niveau de la première face 102 du substrat 100. La valeur de l'angle formé par les parois latérales 110 du ou des trous borgnes 106 avec la première face 102 du substrat 100 est choisie notamment en fonction de la méthode de gravure qui sera mise en oeuvre ultérieurement pour retirer le matériau getter se trouvant sur la première face 102 du substrat 100, comme décrit plus loin.

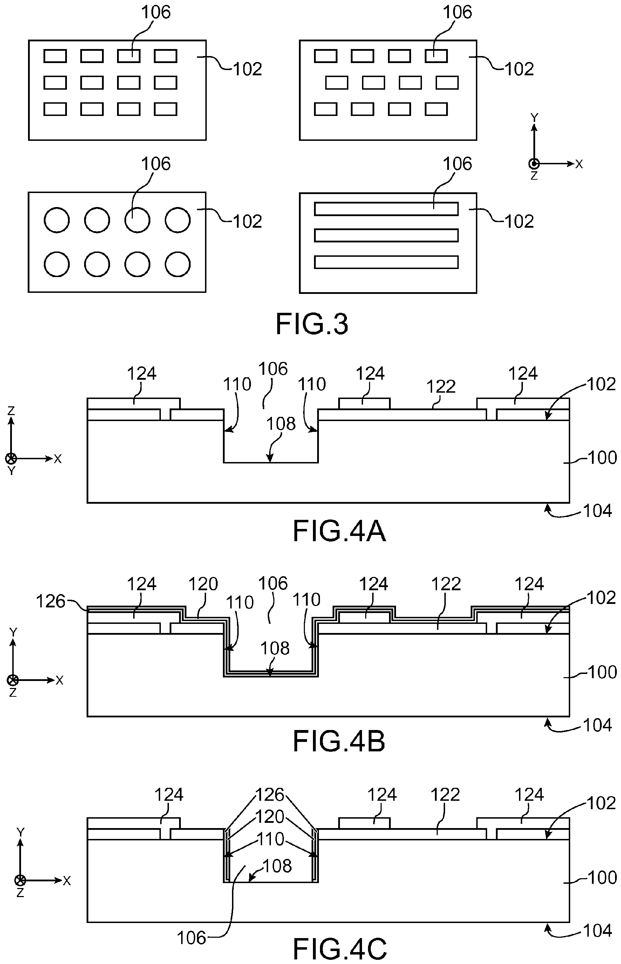

La forme et le nombre de trous borgnes 106 sont déterminés notamment en fonction de la place disponible sur la première face 102 du substrat 100 pour réaliser le ou les trous borgnes 106. La figure 3 représente différents exemples de réalisation de plusieurs trous borgnes 106 formés les uns à côté des autres à travers la première face 102 du substrat 100 (sur ces différents exemples, seule une partie de la première face 102 du substrat 100 est représentée). Dans ces exemples, les trous borgnes 106 ont chacun une section, dans un plan parallèle à la première face 102 du substrat 100, de forme circulaire, rectangulaire, ou correspondent à des tranchées. De plus, les trous borgnes 106 sont disposés en formant un réseau régulier de trous, c'est-à-dire sont régulièrement espacés les uns des autres, afin d'optimiser la surface de la première face 102 du substrat 100 dédiée à ces trous borgnes 106. Ce réseau peut présenter des décalages d'une ligne à l'autre du réseau, les trous borgnes 106 étant dans ce cas disposés en quinconces.

Le ou les trous borgnes 106 sont par exemple réalisés par photolithographie et gravure selon le motif choisi pour ce ou ces trous borgnes 106. La gravure du ou des trous borgnes 106 peut correspondre à une gravure sèche, par exemple de type RIE (gravure ionique réactive) ou DRIE (gravure ionique réactive profonde), ou humide, par exemple avec une solution de type TMAH (hydroxyde de tétraméthylammonium) ou KOH (hydroxyde de potassium) selon la nature du matériau du substrat 100 à graver.

Une couche de matériau getter 120 est ensuite déposée sur le substrat 100, c'est-à-dire sur la première face 102 du substrat 100 ainsi que sur les parois latérales 110 et la paroi de fond 108 du ou de chacun des trous borgnes 106 (figure 1B). L'épaisseur de la couche de matériau getter 120 est par exemple comprise entre environ 100 nm et quelques microns, voir 10 µm. Le dépôt de la couche de matériau getter 120 mis en oeuvre est de préférence conforme, c'est-à-dire que l'épaisseur de la couche de matériau getter 120 est sensiblement constante pour l'ensemble de la couche de matériau getter 120, y compris au niveau des portions de la couche de matériau getter 120 se trouvant sur les parois latérales 110 du ou des trous borgnes 106. Un dépôt non conforme de la couche de matériau getter 120 peut également être mis en oeuvre. Par exemple, si la conformité est faible, par exemple de l'ordre de 30 %, l'épaisseur de la couche de matériau getter 120 déposée peut être plus importante que celle choisie pour un dépôt conforme. Pour obtenir l'épaisseur souhaitée de matériau getter sur les parois latérales 110, en fonction de la technique de dépôt mise en oeuvre, le matériau getter est déposé sur la première face 102 du substrat 100 ainsi que sur la paroi de fond 108 du ou de chacun des trous borgnes 106. En variante, il est possible que la couche de matériau getter 120 ne soit pas déposée sur la paroi de fond 108 du ou de chacun des trous borgnes 106, notamment lorsque le ou les trous borgnes 106 comportent un faible rapport de forme (rapport de la largeur par rapport à la profondeur du trou borgne). Si on souhaite favoriser le dépôt sur les parois de fond 108 des trous borgnes 106 dans le cas de trous borgnes 106 présentant un grand facteur de forme, par exemple supérieur à environ 10, et de section étroite, par exemple inférieure à environ 100 µm², un dépôt de type CVD (dépôt chimique en phase vapeur), ALD (dépôt de couches atomiques) ou IBD (dépôt par faisceau d'ions) est de préférence mis en oeuvre car ces types de dépôt permettent d'obtenir un dépôt plus uniforme, et donc plus conforme.

La couche de matériau getter 120 peut correspondre à une seule couche ou à plusieurs couches de matériaux empilées les unes sur les autres, et être par exemple composée d'un métal ou d'un alliage métallique comportant par exemple du titane et/ou du zirconium et/ou de l'aluminium et/ou du lanthane et/ou de l'hafnium et/ou du chrome et/ou du cobalt et/ou du fer et/ou du magnésium et/ou du manganèse et/ou du molybdène et/ou du niobium et/ou du tantale et/ou du vanadium. La couche de matériau getter 120 peut être réalisée en mettant en oeuvre des procédés similaires à ceux décrits dans les documents FR 2 950 876 B1, ou « NEG thin films for under controlled atmosphère MEMS packaging » de L. Tenchine et al., Sensors and Actuators a-Physical 172(1) (2011) 233-239. La couche de matériau getter 120 est par exemple déposée par PVD (dépôt physique en phase vapeur), pulvérisation cathodique, évaporation par canon à ions ou encore par dépôt par faisceau d'électrons, la technique de dépôt mise en oeuvre dépendant notamment de la nature du matériau getter à déposer. La couche de matériau getter 120 peut également être associée à une couche d'activation et/ou de passivation comme décrit dans le document EP 2 197 780 B1.

Comme représenté sur la figure 1C, les parties de la couche de matériau getter 120 se trouvant sur la première face 102 du substrat 100 et sur la paroi de fond 108 du ou de chacun des trous borgnes 106 sont ensuite gravées telles que seules les parois latérales 110 du ou des trous borgnes 106 restent recouvertes par des parties restantes de la couche de matériau getter 120. Cette gravure correspond par exemple à une gravure RIE ou une gravure par usinage ionique, ou toute autre technique adaptée au retrait de ces parties de la couche de matériau getter 120.

En variante, il est possible que seules les parties de la couche de matériau getter 120 se trouvant sur la première face 102 du substrat 100 soient gravées telles que les parois latérales 110 et la paroi de fond 108 du ou de chacun des trous borgnes 106 soient recouvertes par des parties restantes de la couche de matériau getter 120, comme représenté sur la figure 2. On augmente ainsi la surface de matériau getter se trouvant dans le ou les trous borgnes 106. Lorsque seules les parties de la couche de matériau getter 120 se trouvant sur la première face 102 du substrat 100 sont gravées, cette gravure peut être réalisée via une planarisation mécano-chimique, ou polissage mécano-chimique, avec arrêt sur la première face 102 du substrat 100. Une telle planarisation mécano-chimique est de préférence mise en oeuvre pour supprimer les parties de la couche de matériau getter 120 se trouvant sur la première face 102 du substrat 100 lorsque les parois latérales 110 du ou des trous borgnes 106 ne sont pas perpendiculaires à la première face 102 du substrat 100, comme sur l'exemple de la figure 2.

Parmi les différentes méthodes de gravure du matériau getter précédemment décrites, celles choisies préférentiellement sont la gravure par usinage ionique, la planarisation ou le polissage mécano-chimique. Ces méthodes de gravure sont très directives et, couplées aux trous borgnes, elles permettent de faire une gravure locale du matériau getter sans avoir recours à un masque. En effet, la réalisation d'un tel masque de gravure, par exemple par photolithographie, ajoute un risque de contamination du matériau getter et donc de modification de ses performances. En outre, les méthodes de gravure indiquées ci-dessus sont compatibles avec la gravure de tous les matériaux getter connus, contrairement à d'autres techniques de gravure telles qu'une gravure RIE qui ne peut être utilisée pour graver le Zr par exemple.

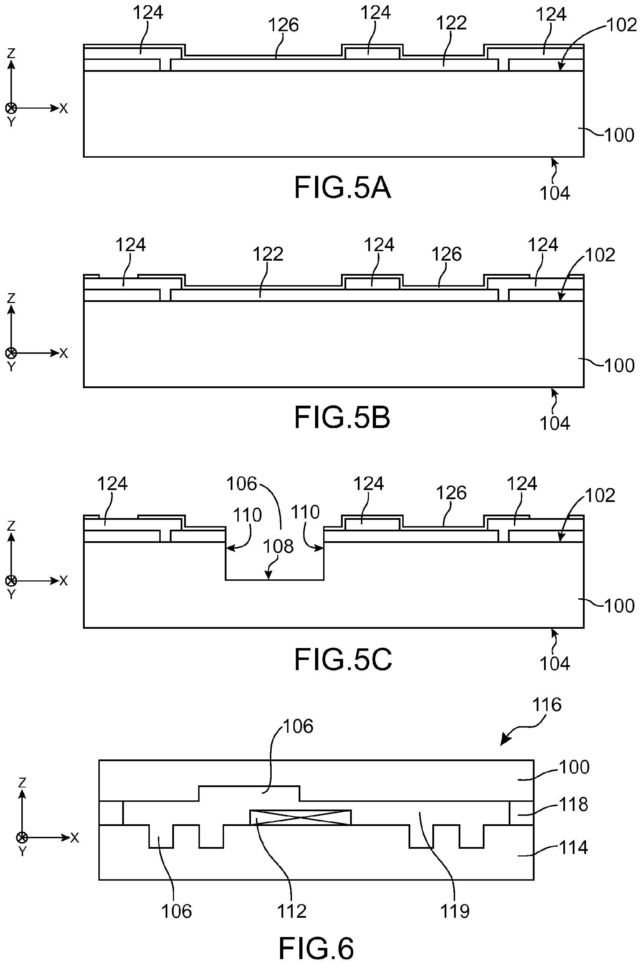

Dans le premier mode de réalisation précédemment décrit, le substrat 100 est destiné à servir de capot lors d'une encapsulation d'un dispositif microélectronique 112, c'est-à-dire à être reporté sur un autre substrat 114, appelé support, sur lequel le dispositif microélectronique 112 est réalisé. Ce substrat 114 peut également comporter des trous borgnes et une couche de matériau getter comme pour le substrat 100. La structure d'encapsulation 116 ainsi obtenue est représentée sur la figure 6, dans laquelle le substrat 100 formant le capot est solidarisé au substrat formant le support 114 par une interface de collage 118, formant une cavité 119 dans laquelle le dispositif microélectronique 112 est encapsulé. De plus, bien que cela ne soit pas visible sur cette figure 6, les parois latérales, ainsi qu'éventuellement les parois de fond, des trous borgnes 106 sont recouvertes par du matériau getter. En variante, il est possible que le substrat 100 précédemment décrit comporte un tel dispositif microélectronique 112 réalisé sur sa première face 102 et que ce substrat 100 forme alors le support de la structure d'encapsulation 116, le ou les trous borgnes 106 dont les parois sont recouvertes de matériau getter étant réalisés à côté du dispositif microélectronique 112. Ainsi, il est possible qu'un ou plusieurs trous borgnes dont les parois latérales et éventuellement les parois de fond sont recouvertes par du matériau getter soient réalisés dans le substrat formant le capot et/ou dans le substrat formant le support d'une telle structure d'encapsulation 116. Dans tous les cas, les trous borgnes 106 sont réalisés sur le ou les substrats 100, 114 en fonction de la place disponible sur ces derniers.

Selon une autre variante, le substrat 100 peut avoir une fonction d'interposeur et être disposé entre un capot et un support d'une structure d'encapsulation, ou encore être disposé entre des puces électroniques et un support. En outre, le substrat 100 peut comporter, sur sa première face 102, des fonctionnalités telles que des lignes électriques et/ou des éléments de contact électrique, et cela quel que soit le rôle du substrat 100 (capot, support ou interposeur par exemple).

On se réfère maintenant aux figures 4A à 4C qui représentent les étapes d'un exemple de procédé de réalisation d'un substrat comportant au moins un matériau getter disposé sur des parois d'au moins un trou borgne selon un deuxième mode de réalisation. Les figures 4A à 4C sont des vues en coupe de profil du substrat réalisé. Dans ce deuxième mode de réalisation, le substrat 100 est destiné à former le support d'une structure d'encapsulation dans laquelle un dispositif microélectronique, réalisé sur le substrat 100 (non visible sur les figures 4A à 4C), est encapsulé.

Par rapport au substrat 100 précédemment décrit en liaison avec le premier mode de réalisation, le substrat 100 selon ce deuxième mode de réalisation comporte une première couche diélectrique 122, par exemple à base de SiO₂, formée sur la première face 102 du substrat 100 et permettant d'isoler électriquement des éléments électriquement conducteurs 124, par exemple à base d'AICu, vis-à-vis du substrat 100. Ces éléments électriquement conducteurs 124 sont par exemple des électrodes, des lignes électriques ou encore des plots de contact électrique, disposés sur la première couche diélectrique 122 et venant éventuellement contacter électriquement le substrat 100 à travers la première couche diélectrique 122. En variante, les éléments présents sur le substrat 100 pourraient être différents, correspondant par exemple à ceux d'une structure mécanique réalisée sur le substrat 100.

Comme précédemment décrit en liaison avec la figure 1A, un ou plusieurs trous borgnes 106 sont gravés à travers la première face 102 du substrat 100 et dans une partie de l'épaisseur du substrat 100. Le ou les trous borgnes 106 sont également gravés à travers la première couche diélectrique 122 (figure 4A).

Préalablement au dépôt de la couche de matériau getter 120, une couche diélectrique de protection 126 est déposée de manière conforme sur la première face 102 du substrat 100, recouvrant ainsi les éléments électriquement conducteurs 124 et la première couche diélectrique 122, ainsi que sur les parois latérales 110 et la paroi de fond 108 du ou de chacun des trous borgnes 106. Le matériau de la couche diélectrique de protection 126 est choisi en fonction de sa compatibilité avec les matériaux en présence (c'est-à-dire notamment ceux du substrat 100, de la première couche diélectrique 122 et des éléments 124), ainsi qu'en fonction du matériau getter destiné à être déposé par la suite. De plus, le matériau de la couche diélectrique de protection 126 est choisi tel qu'il soit résistant à la gravure du matériau getter qui sera mise en oeuvre ultérieurement. Ainsi, la couche diélectrique de protection 126 est par exemple à base d'un oxyde, tel que du SiO₂, par exemple déposé par PECVD (dépôt chimique en phase vapeur assisté par plasma), et comporte une épaisseur par exemple comprise entre quelques dizaines de nanomètres, par exemple 20 nm, et quelques microns, par exemple 9 µm. La couche de matériau getter 120 est ensuite déposée sur la couche diélectrique de protection 126 (figure 4B).

Comme représenté sur la figure 4C, les parties de la couche de matériau getter 120 et de la couche diélectrique de protection 126 se trouvant sur la première face 102 du substrat 100 (et recouvrant les éléments électriquement conducteurs 124 et la première couche diélectrique 122) et sur la paroi de fond 108 du ou de chacun des trous borgnes 106 sont ensuite gravées telles que seules les parois latérales 110 du ou des trous borgnes 106 soient recouvertes par des parties restantes de la couche diélectrique de protection 126 et de la couche de matériau getter 120. La gravure de ces parties de la couche de matériau getter 120 et de la couche diélectrique de protection 126 est par exemple réalisée par une technique similaire à celle précédemment décrite en liaison avec le premier mode de réalisation pour graver le matériau getter. Cette gravure des parties de la couche de matériau getter 120 recouvrant les éléments électriquement conducteurs 124 permet d'éviter un bruit électrique qui serait engendré par la présence du matériau getter sur ces éléments électriquement conducteurs 124. De plus, les parties de la couche diélectrique de protection 126 se trouvant sur les parois latérales 110 du ou des trous borgnes assurent une isolation électrique de ces parois, notamment vis-à-vis du matériau getter localisé sur ces parois.

En variante, il est possible que seules les parties de la couche de matériau getter 120 et de la couche diélectrique de protection 126 se trouvant sur la première face 102 du substrat 100 soient gravées telles que les parois latérales 110 et la paroi de fond 108 du ou de chacun des trous borgnes 106 soient recouvertes par les parties restantes de la couche de matériau getter 120 et de la couche diélectrique de protection 126. On augmente ainsi la surface de matériau getter se trouvant dans le ou les trous borgnes 106 tout en isolant électriquement toutes les parois du ou des trous borgnes 106 notamment vis-à-vis du matériau getter. Selon une autre variante, il est possible que seules les parties de la couche de matériau getter 120 se trouvant sur la première face 102 du substrat 100, et éventuellement sur la paroi de fond 108 du ou de chacun des trous borgnes 106, soient gravées, la couche diélectrique de protection 126 pouvant être conservée sur la paroi de fond 108 du ou de chacun des trous borgnes 106 et/ou sur la première face 102 du substrat 100.

On se réfère maintenant aux figures 5A à 5C qui représentent les étapes d'un procédé de réalisation d'un substrat comportant au moins un matériau getter disposé sur des parois d'au moins un trou borgne selon une variante du deuxième mode de réalisation précédemment décrit.

Contrairement au deuxième mode de réalisation précédemment décrit en liaison avec les figures 4A à 4C dans lequel le ou le trous borgnes 106 sont réalisés préalablement au dépôt de la couche diélectrique de protection 126, la couche diélectrique de protection 126 est ici déposée sur la deuxième face 102 du substrat 100, c'est-à-dire sur les éléments électriquement conducteurs 124 et sur la première couche diélectrique 122, préalablement à la réalisation du ou des trous borgnes 106 (figure 5A).

La couche diélectrique de protection 126 est ensuite structurée par gravure afin de ne conserver que les parties de cette couche diélectrique de protection 126 se trouvant sur les surfaces à protéger, comme représenté sur la figure 5B. En outre, cette étape de gravure permet également de réaliser des accès aux éléments électriquement conducteurs 124 formant des plots de contact. Toutefois, cette étape de structuration de la couche diélectrique de protection 126 peut être omise s'il n'est pas nécessaire de former de tels accès.

Le ou les trous borgnes 106 sont ensuite gravés à travers la couche diélectrique de protection 126, la première couche diélectrique 122 et à travers la deuxième face 102 du substrat 100, comme décrit pour les précédents exemples et modes de réalisation (figure 5C). La couche de matériau getter 120 est ensuite déposée puis gravée comme précédemment décrit dans les précédents exemples et modes de réalisation. Ainsi, la couche diélectrique de protection 126 assure la protection des éléments se trouvant sur la première face 102 du substrat 100.

Il est possible que seules les parties de la couche de matériau getter 120 se trouvant sur la première face 102 du substrat 100, et éventuellement sur la paroi de fond 108 du ou de chacun des trous borgnes 106, soient gravées, la couche diélectrique de protection 126 pouvant être conservée sur la première face 102 du substrat 100.

En variante, les éléments présents sur le substrat 100 pourraient être différents, correspondant par exemple à ceux d'une structure mécanique réalisée sur le substrat 100.

Les différents exemples et variantes précédemment décrits en liaison avec le premier mode de réalisation s'appliquent également au deuxième mode de réalisation décrit en liaison avec les figures 4A à 4C ainsi qu'à la variante de réalisation décrite en liaison avec les figures 5A à 5C. Inversement, le procédé selon le premier mode de réalisation précédemment décrit peut également être mis en oeuvre en présence de la première couche diélectrique 122 et/ou des éléments électriquement conducteurs 124 et/ou de la couche diélectrique de protection 126 comme décrit en liaison avec les figures 4A à 4C ou 5A à 5C.

## Revendications

1. Procédé d'encapsulation d'au moins un dispositif microélectronique (112), comportant la mise en oeuvre d'un procédé de réalisation d'un substrat (100) comportant au moins un matériau getter disposé sur des parois d'au moins un trou borgne (106), le procédé de réalisation du substrat (100) comportant au moins les étapes de :
- gravure du trou borgne (106) à travers une première face (102) du substrat (100),
- dépôt d'une couche de matériau getter (120) de manière continue sur l'ensemble de la première face (102) du substrat (100) et au moins sur des parois latérales (110) du trou borgne (106),
- gravure d'une partie de la couche de matériau getter (120) se trouvant sur la première face (102) du substrat (100) telle que ladite première face (102) du substrat (100) ne soit plus recouverte par le matériau getter,
et dans lequel l'étape de gravure d'une partie de la couche de matériau getter (120) comporte la mise en oeuvre d'une gravure par usinage ionique, ou une planarisation ou un polissage mécano-chimique,
le procédé d'encapsulation comportant en outre une étape d'encapsulation du dispositif microélectronique (112) dans une cavité (119) dont une ou plusieurs parois sont formées par ledit substrat (100) et telle que le ou les trous borgnes (106) sont disposés dans la cavité (119), le dispositif microélectronique (112) étant réalisé sur ledit substrat (100) ou ledit substrat (100) formant un capot de la cavité (119) dans laquelle le dispositif microélectronique (112) est encapsulé.

2. Procédé selon la revendication 1, dans lequel la couche de matériau getter (120) est également déposée sur une paroi de fond (108) du trou borgne (106).

3. Procédé selon la revendication 2, dans lequel l'étape de gravure d'une partie de la couche de matériau getter (120) est mise en oeuvre telle que le matériau getter déposé sur la paroi de fond (108) du trou borgne (106) soit également gravé.

4. Procédé selon l'une des revendications précédentes, comportant en outre, entre l'étape de gravure du trou borgne (106) et l'étape de dépôt de la couche de matériau getter (120), une étape de dépôt d'une couche diélectrique de protection (126) sur la première face (102) du substrat (100) et au moins sur les parois latérales (110) du trou borgne (106), la couche de matériau getter (120) étant déposée ensuite sur la couche diélectrique de protection (126).

5. Procédé selon la revendication 4, dans lequel l'étape de gravure d'une partie de la couche de matériau getter (120) réalise également la gravure d'une partie de la couche diélectrique de protection (126) se trouvant sur la première face (102) du substrat (100) telle que ladite première face (102) du substrat (100) ne soit plus recouverte par la couche diélectrique de protection (126).

6. Procédé selon l'une des revendications 1 à 3, comportant en outre, avant l'étape de gravure du trou borgne (106), une étape de dépôt d'une couche diélectrique de protection (126) sur la première face (102) du substrat (100), le trou borgne (106) étant ensuite gravé également à travers la couche diélectrique de protection (126).

7. Procédé selon l'une des revendications précédentes, dans lequel le trou borgne (106) comporte, dans un plan parallèle à la première face (102) du substrat (100), une section de forme circulaire et/ou polygonale, ou dans lequel le trou borgne (106) forme une tranchée traversant une partie de l'épaisseur du substrat (100).

8. Procédé selon l'une des revendications précédentes, dans lequel l'étape de gravure du trou borgne (106) forme plusieurs trous borgnes (106) à travers la première face (102) du substrat (100), et la couche de matériau getter (120) est déposée au moins sur les parois latérales (110) des trous borgnes (106).

9. Procédé selon la revendication 8, dans lequel au moins une partie des trous borgnes (106) sont réalisés sous la forme d'un réseau régulier de trous.

10. Procédé selon l'une des revendications précédentes, comportant en outre, avant l'étape de gravure du trou borgne (106), une étape de :
- réalisation d'au moins un dispositif microélectronique (112) sur la première face (102) du substrat (100), le ou les trous borgnes (106) étant gravés à côté du dispositif microélectronique (112), et/ou
- réalisation d'au moins un élément électriquement conducteur (124) sur la première face (102) du substrat (100), le ou les trous borgnes (106) étant gravés à côté de l'élément électriquement conducteur (124).

11. Procédé selon l'une des revendications précédentes, dans lequel la couche de matériau getter (120) comporte du titane et/ou du zirconium et/ou de l'aluminium et/ou du lanthane et/ou de l'hafnium et/ou du chrome et/ou du cobalt et/ou du fer et/ou du magnésium et/ou du manganèse et/ou du molybdène et/ou du niobium et/ou du tantale et/ou du vanadium.

## Patentansprüche

1. Verfahren zum Einkapseln zumindest einer mikroelektronischen Vorrichtung (112), umfassend das Durchführen eines Verfahrens zum Herstellen zumindest eines Substrats (100), das zumindest ein Gettermaterial enthält, das an Wänden von zumindest einem Sackloch (106) angeordnet wird, wobei das Verfahren zum Herstellen des Substrats (100) zumindest die nachfolgenden Schritte umfasst:
- Ätzen des Sacklochs (106) durch eine erste Seite (102) des Substrats (100),
- Abscheiden einer Gettermaterialschicht (120) in kontinuierlicher Weise auf die gesamte erste Seite (102) des Substrats (100) und zumindest auf Seitenwände (110) des Sacklochs (106),
- Ätzen eines Teils der Gettermaterialschicht (120), der sich auf der ersten Seite (102) des Substrats (100) befindet, derart, dass die erste Seite (102) des Substrats (100) nicht mehr mit dem Gettermaterial bedeckt ist,
wobei der Schritt des Ätzens eines Teils der Gettermaterialschicht (120) das Durchführen eines Ätzvorgangs durch lonenfräsung oder ein Planpolieren oder ein mechanisch-chemisches Polieren umfasst,
wobei das Einkapselungsverfahren ferner einen Schritt des Einkapselns der mikroelektronischen Vorrichtung (112) in einer Vertiefung (119) umfasst, von der eine oder mehrere Wände aus dem Substrat (100) gebildet sind, derart, dass das bzw. die Sacklöcher (106) in der Vertiefung (119) angeordnet sind, wobei die mikroelektronische Vorrichtung (112) an dem Substrat (100) ausgebildet ist oder das Substrat (100) eine Haube für die Vertiefung (119) bildet, in welche die mikroelektronische Vorrichtung (112) eingekapselt wird.

2. Verfahren nach Anspruch 1, wobei die Gettermaterialschicht (120) auch auf eine Bodenwand (108) des Sacklochs (106) abgeschieden wird.

3. Verfahren nach Anspruch 2, wobei der Schritt des Ätzens eines Teils der Gettermaterialschicht (120) derart durchgeführt wird, dass auch das auf die Bodenwand (108) des Sacklochs (106) abgeschiedene Gettermaterial geätzt wird.

4. Verfahren nach einem der vorangehenden Ansprüche, ferner umfassend zwischen dem Schritt des Ätzens von dem Sackloch (106) und dem Schritt des Abscheidens der Gettermaterialschicht (120) einen Schritt des Abscheidens einer dielektrischen Schutzschicht (126) auf die erste Seite (102) des Substrats (100) und zumindest auf die Seitenwände (110) des Sacklochs (106), wobei die Gettermaterialschicht (120) dann auf die dielektrische Schutzschicht (126) abgeschieden wird.

5. Verfahren nach Anspruch 4, wobei mit dem Schritt des Ätzens eines Teils der Gettermaterialschicht (120) auch das Ätzen eines Teils der dielektrischen Schutzschicht (126) erfolgt, die sich auf der ersten Seite (102) des Substrats (100) befindet, so dass die erste Seite (102) des Substrats (100) nicht mehr von der dielektrischen Schutzschicht (126) bedeckt wird.

6. Verfahren nach einem der Ansprüche 1 bis 3, ferner umfassend vor dem Schritt des Ätzens von dem Sackloch (106) einen Schritt des Abscheidens einer dielektrischen Schutzschicht (126) auf die erste Seite (102) des Substrats (100), wobei das Sackloch (106) dann auch durch die dielektrische Schutzschicht (126) geätzt wird.

7. Verfahren nach einem der vorangehenden Ansprüche, wobei das Sackloch (106) in einer parallel zur ersten Seite (102) des Substrats (100) verlaufenden Ebene einen kreisförmigen und/oder polygonalen Querschnitt aufweist oder wobei das Sackloch (106) einen Graben bildet, der einen Teil der Dicke des Substrats (100) durchsetzt.

8. Verfahren nach einem der vorangehenden Ansprüche, wobei mit dem Schritt des Ätzens von dem Sackloch (106) mehrere Sacklöcher (106) durch die erste Seite (102) des Substrats (100) gebildet werden, und die Gettermaterialschicht (120) zumindest auf die Seitenwände (110) der Sacklöcher (106) abgeschieden wird.

9. Verfahren nach Anspruch 8, wobei zumindest ein Teil der Sacklöcher (106) in Form eines gleichmäßigen Arrays von Löchern ausgebildet wird.

10. Verfahren nach einem der vorangehenden Ansprüche, ferner umfassend vor dem Schritt des Ätzens von dem Sackloch (106) einen Schritt zum
- Herstellen zumindest einer mikroelektronischen Vorrichtung (112) auf der ersten Seite (102) des Substrats (100), wobei das bzw. die Sacklöcher (106) neben der mikroelektronischen Vorrichtung (112) geätzt werden, und/oder
- Herstellen zumindest eines elektrisch leitfähigen Elements (124) auf der ersten Seite (102) des Substrats (100), wobei das bzw. die Sacklöcher (106) neben dem elektrisch leitfähigen Element (124) geätzt werden.

11. Verfahren nach einem der vorangehenden Ansprüche, wobei die Gettermaterialschicht (120) Titan und/oder Zirkonium und/oder Aluminium und/oder Lanthan und/oder Hafnium und/oder Chrom und/oder Kobalt und/oder Eisen und/oder Magnesium und/oder Mangan und/oder Molybdän und/oder Niob und/oder Tantal und/oder Vanadium enthält.

## Claims

1. Method of encapsulation of at least one microelectronic device (112), comprising the implementation of a method for producing a substrate (100) comprising at least one getter material arranged on the walls of at least one blind hole (106), the method for producing the substrate (100) comprising at least the steps of:
- etching the blind hole (106) through a first face (102) of the substrate (100),
- depositing a layer of getter material (120) in a continuous manner on the whole of the first face (102) of the substrate (100) and at least on side walls (110) of the blind hole (106),
- etching part of the layer of getter material (120) located on the first face (102) of the substrate (100) such that said first face (102) of the substrate (100) is no longer covered by the getter material,
in which the step of etching part of the layer of getter material (120) comprises the implementation of an etching by ion beam machining, or chemical-mechanical planarization or polishing,
the method of encapsulation further comprising a step of encapsulation of the microelectronic device (112) in a cavity (119) in which one or several walls are formed by said substrate (100) and such that the blind hole(s) (106) are arranged in the cavity (119), the microelectronic device (112) being made on said substrate (100) or said substrate (100) forming a cover of the cavity (119) in which the microelectronic device (112) is encapsulated.

2. Method according to claim 1, in which the layer of getter material (120) is also deposited on a bottom wall (108) of the blind hole (106).

3. Method according to claim 2, in which the step of etching part of the layer of getter material (120) is implemented such that the getter material deposited on the bottom wall (108) of the blind hole (106) is also etched.

4. Method according to one of preceding claims, further comprising, between the step of etching the blind hole (106) and the step of depositing the layer of getter material (120), a step of depositing a protective dielectric layer (126) on the first face (102) of the substrate (100) and at least on the side walls (110) of the blind hole (106), the layer of getter material (120) then being deposited on the protective dielectric layer (126).

5. Method according to claim 4, in which the step of etching part of the layer of getter material (120) also carries out the etching of part of the protective dielectric layer (126) located on the first face (102) of the substrate (100) such that said first face (102) of the substrate (100) is no longer covered by the protective dielectric layer (126).

6. Method according to one of claims 1 to 3, further comprising, before the step of etching the blind hole (106), a step of depositing a protective dielectric layer (126) on the first face (102) of the substrate (100), the blind hole (106) then also being etched through the protective dielectric layer (126).

7. Method according to one of previous claims, in which the blind hole (106) comprises, in a plane parallel to the first face (102) of the substrate (100), a section of circular and/or polygonal shape, or in which the blind hole (106) corresponds to a trench passing through part of the thickness of the substrate (100).

8. Method according to one of previous claims, in which the step of etching the blind hole (106) makes several blind holes (106) through the first face (102) of the substrate (100), and the layer of getter material (120) is deposited at least on the side walls (110) of the blind holes (106).

9. Method according to claim 8, in which at least one part of the blind holes (106) are produced as a regular network of holes.

10. Method according to one of previous claims, further comprising, before the step of etching the blind hole (106), a step of:
- making of at least one microelectronic device (112) on the first face (102) of the substrate (100), the blind hole(s) (106) being etched next to the microelectronic device (112), and/or
- making of at least one electrically conductive element (124) on the first face (102) of the substrate (100), the blind hole(s) (106) being etched next to the electrically conductive element (124).

11. Method according to one of previous claims, in which the layer of getter material (120) comprises titanium and/or zirconium and/or aluminium and/or lanthanum and/or hafnium and/or chromium and/or cobalt and/or iron and/or magnesium and/or manganese and/or molybdenum and/or niobium and/or tantalum and/or vanadium.
